# EUROPEAN PATENT APPLICATION

(11) **EP 2 650 914 A2**
(43) Date of publication of application: **16.10.2013**
(21) Application number: 12186001.9
(22) Date of filing: 26.09.2012
(51) Int. Cl.: H01L 23/373

(54) **Heat dissipation module with multiple porosities**

(30) Priority: 12.04.2012 TW 101206705 U
(71) Applicant: Ni, Chin Huan, Taoyuan County 32456 (TW)
(72) Inventor: Ni, Chin Huan, Taoyuan County 32456 (TW)
(74) Representative: Bucher, Ralf Christian

(57) **Abstract**

A heat dissipation module with multiple porosities is used for cooling the connected heating electrical components and comprises: a cooling body, a thermal conductive part, and a heating electrical component. The cooling body is a kind of composite ceramic with multiple porosities, and the cooling body comprises at least a cavity to accommodate the thermal conductive part. The heating electrical component is a piece of PCB with electrical conductive circuits and lighting device or a CPU.

## Description

### FIELD OF THE INVENTION

The present invention relates to a heat dissipation module, especially for a new type of ceramic heat dissipation module.

### BACKGROUND OF THE INVENTION

All of LED (Light Emitting Diode), CPU, and various electrical power computing components usually need a suitable heat sink heat dissipation module to provide their best performance. The required spec of heat dissipation module comprises: heat conductive ability, heat dissipation ability, space, outlook, material adaptability, and safety regulation commitment. The most popular and well used heat dissipation module's material at this current market is metal. Ceramic heat dissipation modules are also very popular in power devices or LED integrated lights. Plastic heat dissipation modules are more and more used in LED lighting modules.

Traditional heat dissipation modules usually cannot perform their best heat sink performance because they are made by single material. Different materials provide different and specific characteristics. And, to use suitably, heat dissipation modules' usability and performance might be able to highly enhanced by integrated different materials in a heat dissipation module together efficiently and to improve the disadvantage of traditional technology.

### SUMMARY OF THE INVENTION

The main objective of the present invention is to provide a heat dissipation module to enhance heat dissipation ability very efficiently and to integrate with multiple different materials.

### BRIEF DESCRIPTION OF THE INVENTION

According to the present invention, a new and advanced heat dissipation module comprises the following components:

A heat dissipation module with multiple porosities, which is used to cool the thermal of its connected heating electrical component, comprises a cooling body, a thermal conductive part, and a heating electrical component. The cooling body is a composite ceramic with multiple porosities, and the cooling body comprises at least a cavity to accommodate the thermal conductive part inside.

According to the present invention, the heat dissipation module with multiple porosities comprises a cooling body and a heating electrical component, in which the heating electrical component is located on the cooling body, which is made by composite ceramic with multiple porosities, and the cooling body comprises at least a cavity to decrease the weight of the heat dissipation module.

In accordance with one aspect of the present invention, the cooling body is made by SiC or other ceramic or glass materials to achieve the expected heat sink ceramic with multiple porosities.

In accordance with one aspect of the present invention, the heating electrical component is a lighting device with electrical conductive circuits, a CPU, a conductor, or a semi-conductor device made on the heat dissipation module with multiple porosities.

In order to enhance the heat dissipation ability of the heat dissipation module, the porosity of cooling body is 1% to 50%.

In order to enhance the heat dissipation ability of the heat dissipation module, the aperture of porosity is 0.001 to 50 um.

In order to enhance the heat dissipation ability and optimize the heat conductive ability of the heat dissipation module, another heat conductive device is arranged between the heating electrical component and cooling body.

Furthermore, in order to optimize the heat conductive ability of the cooling body in advance, the surface of the cooling body is designed to have multiple trenches.

The present invention relates to a composite ceramic heat dissipation module with multiple porosities as a heat sink device, arranges the thermal conductive part inside the cooling body for decreasing the resistance of thermal conductive and then enhances the heat dissipation ability. And for a low power consumption device, to use the cooling body without thermal conductive part in its cavity can also decrease the heat dissipation module's weight.

The present invention may best be understood through the following description with reference to the accompanying drawings, in which:

### BRIEF DESCRIPTION OF THE DRAWINGS

Fig.1 shows the schematic diagram of the executive embodiment 1 to the present invention of heat dissipation module with multiple porosities;
Fig.2 shows another schematic diagram of the executive embodiment 1 to the present invention of heat dissipation module with multiple porosities;
Fig.3 shows the schematic diagram of the executive embodiment 2 to the present invention of heat dissipation module with multiple porosities;
Fig.4 shows another schematic diagram of the executive embodiment 2 to the present invention of heat dissipation module with multiple porosities;
Fig. 5 shows the schematic diagram of the executive embodiment 3 to the present invention of heat dissipation module with multiple porosities;
Fig.6 shows another schematic diagram of the executive embodiment 3 to the present invention of heat dissipation module with multiple porosities;
Fig.7 shows the schematic diagram of the executive embodiment 4 to the present invention of heat dissipation module with multiple porosities;
Fig. 8 shows another schematic diagram of the executive embodiment 4 to the present invention of heat dissipation module with multiple porosities;
Fig.9 shows the schematic diagram of the executive embodiment 5 to the present invention of heat dissipation module with multiple porosities;
Fig.10 shows another schematic diagram of the executive embodiment 5 to the present invention of heat dissipation module with multiple porosities.

### DETAILED DESCRIPTION OF THE PREFERRED EMBODIMENT

The present invention may best be understood through the following description with reference to the accompanying drawings.

### Executive embodiment 1

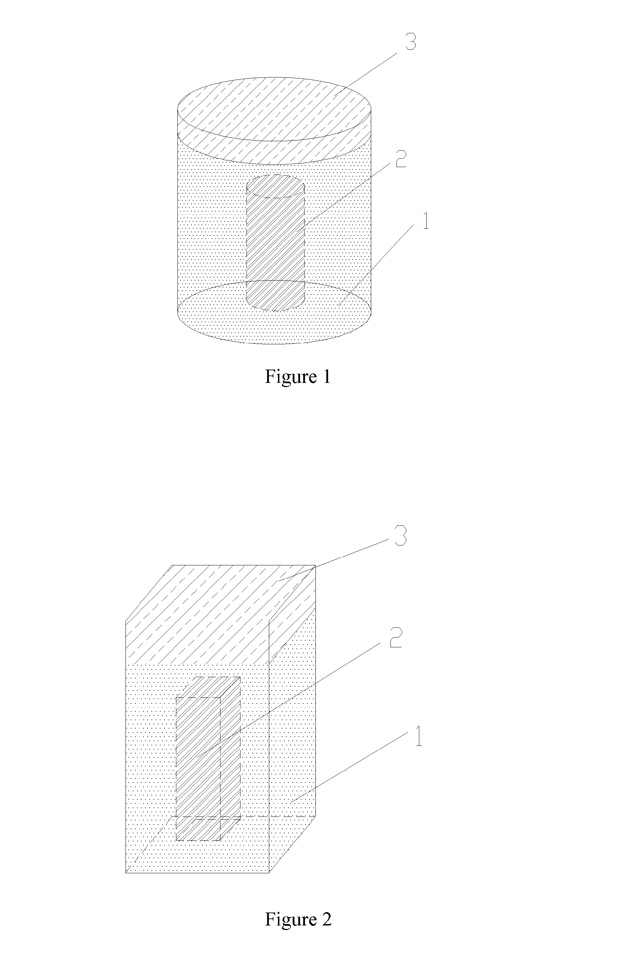

Fig. 1 and Fig. 2 show the schematic diagrams of the executive embodiment to the present invention of heat dissipation module with multiple porosities, in which comprises cooling body 1, thermal conductive part 2, and heating electrical component 3. The cooling body 1 is a composite ceramic with multiple porosities, which aperture is 1 to 3µm. The porosity is 28 to 34%, the cooling body 1 has a cavity, and thermal conductive part 2 is embedded in this cavity.

The heating electrical component 3 is located on the top of the cooling body 1, in which the heating electrical component 3 is a CPU, a LED module with electrical circuits, or a conductor or a semi-conductor.

### Executive embodiment 2

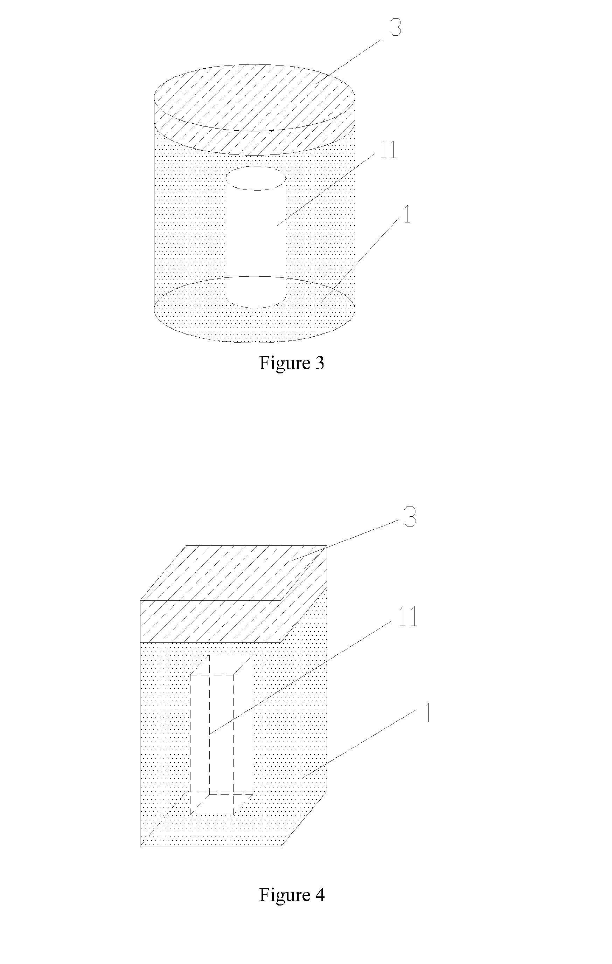

Fig. 3 and Fig. 4 show other schematic diagrams of the executive embodiment to the present invention of heat dissipation module with multiple porosities, in which comprises a cooling body 1 and a heating electrical component 3. The cooling body 1 is a composite ceramic with multiple porosities, which aperture is 1 to 3µm. The porosity is 28 to 34%, the cooling body 1 has a cavity 11, and the heating electrical component 3 is located on the top of the cooling body 1, in which the heating electrical component 3 is a CPU, a LED module with electrical circuits, or a conductor or a semi-conductor.

In accordance with the executive embodiment to the present invention of heat dissipation module with multiple porosities, the structure is adaptive on the modules with low heating level, the ceramic schematic is able to efficiently decrease the weight of module, and also enhances the cooling ability of the cooling body 1.

### Executive embodiment 3

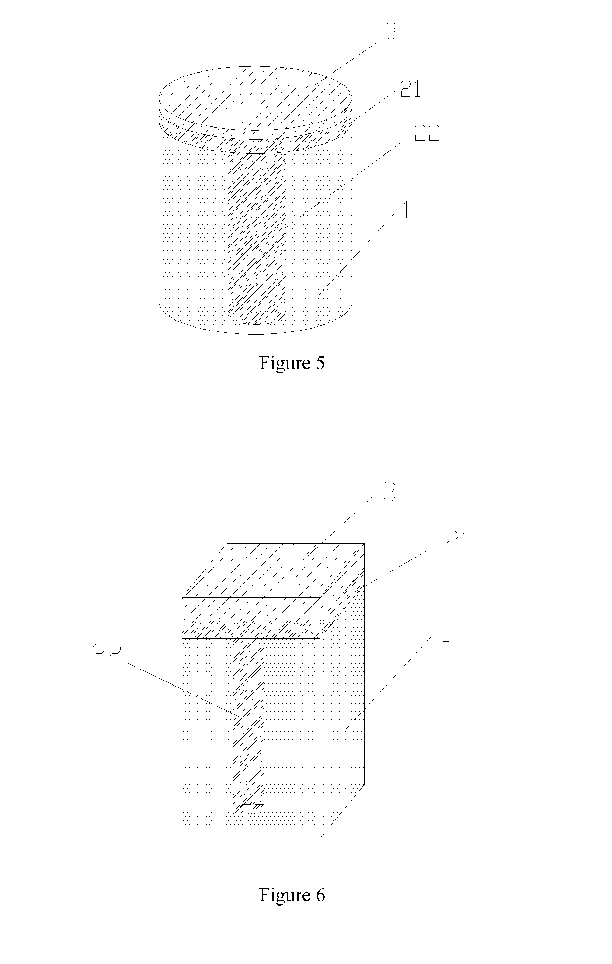

Fig. 5 and Fig. 6 show other schematic diagrams of the executive embodiment to the present invention of heat dissipation module with multiple porosities, in which comprises a cooling body 1 and a heating electrical component 3; the heating electrical component 3 is located on the top of the cooling body 1, and the heating electrical component 3 is a CPU, a LED module with electrical circuits, or a conductor or a semi-conductor embedded on the heat dissipation module with multiple porosities. The first thermal conductive part 21 is located between the heating electrical component 3 and the cooling body 1, in which the cooling body 1 is a composite ceramic with multiple porosities, which aperture is 0.5 to 1.5µm. The porosity is 32 to 36%, the cooling body 1 has a cavity, and the second thermal conductive part 22 is embedded in this cavity.

In accordance with the executive embodiment to the present invention of heat dissipation module with multiple porosities, integrating the first thermal conductive part 21 and the second thermal conductive part 22 at the same time is able to enhance the heat conductive ability of the heat dissipation module efficiently.

### Executive embodiment 4

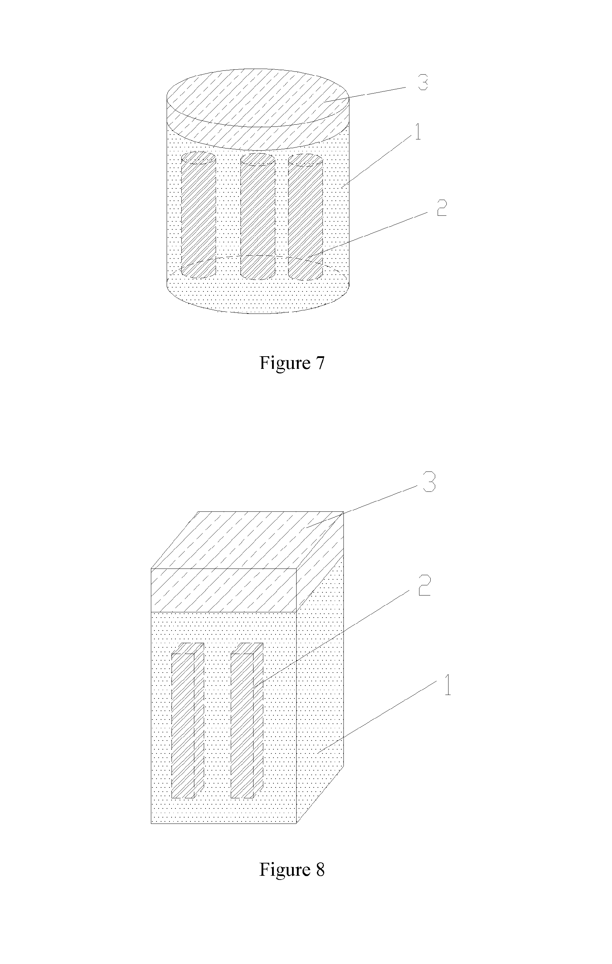

Fig. 7 shows a schematic diagram of the executive embodiment to the present invention of heat dissipation module with multiple porosities, in which comprises a cooling body 1, a thermal conductive part 2, and a heating electrical component 3; the cooling body 1 is a cylinder composite ceramic with multiple porosities, which aperture is 0.2 to 0.6µm. The porosity is 28 to 32%, there are 3 cavities in the cooling body 1, these 3 cavities are parallel to each other and accommodate a corresponding thermal conductive part 2, respectively.

The heating electrical component 3 is located on the top of the cooling body 1, in which the heating electrical component 3 is a CPU, a LED module with electrical circuits, or a conductor or a semi-conductor made on the heat dissipation module with multiple porosities.

Fig. 8 shows a schematic diagram of the executive embodiment to the present invention of heat dissipation module with multiple porosities, in which the heat dissipation module is a cuboid.

### Executive embodiment 5

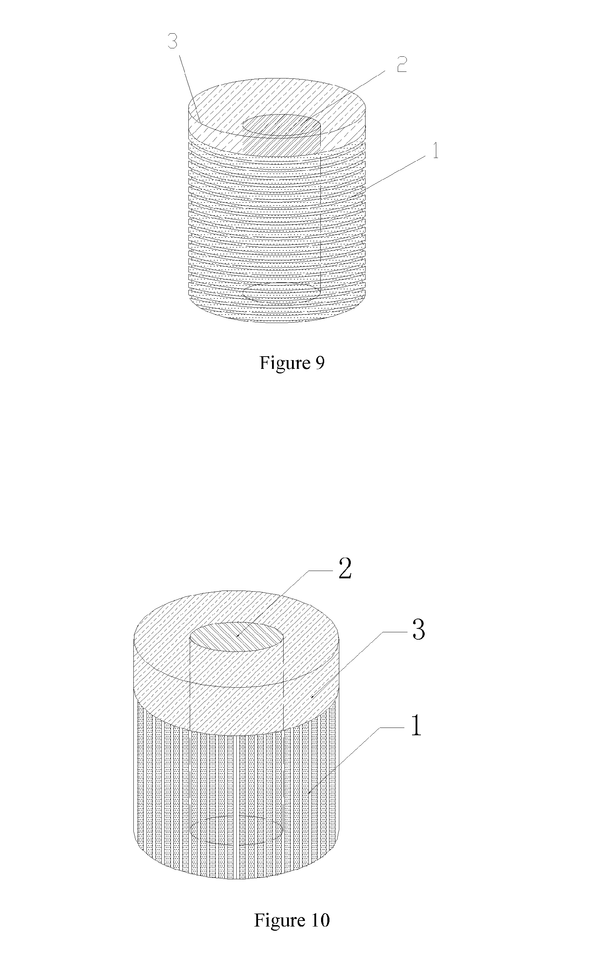

Fig. 9 shows a schematic diagram of the executive embodiment to the present invention of heat dissipation module with multiple porosities, in which comprises a cooling body 1, a thermal conductive part 2, and a heating electrical component 3; the heating electrical component 3 is located on the top of the cooling body 1 and it is a CPU, a LED module with electrical circuits, or a conductor or a semi-conductor made on the heat dissipation module with multiple porosities. The cooling body 1 is a cylinder composite ceramic with multiple porosities, which aperture is 0.6 to 0.8µm. The porosity is 30 to 40%, in order to enlarge the surface for cooling, there are multiple fillisters on the sidewalls of the cooling body 1 as shown in Fig. 10, in which the fillisters can be designed by lateral or by vertical; there is a cavity located in the central of the cooling body 1 without accommodating any thermal conductive part to decrease the weight of heat dissipation module, or to accommodate the LED or other driver modules of other electrical component.

Since various modifications can be made in the invention as hereinabove described, and many apparently widely different embodiments of same made within the spirit and scope of the claims without departing from such spirit and scope, it is intended that all matter contained in the accompanying specification shall be interpreted as illustrative only and not in a limiting sense.

## Claims

1. A heat dissipation module having multiple porosities comprising a cooling body, a thermal conductive part, and a heating electrical component, the heating electrical component being located on the top of the cooling body, the cooling body being made by composite ceramic with multiple porosities, the cooling body comprising at least a cavity to accommodate the thermal conductive part inside the cavity.

2. A heat dissipation module with multiple porosities comprising a cooling body and a heating electrical component, the heating electrical component being located on the top of the cooling body, and the cooling body being made by composite ceramic with multiple porosities, the cooling body comprising at least a cavity.

3. The heat dissipation module according to claim 1 or claim 2, wherein the porosity of the cooling body is 1 to 50%.

4. The heat dissipation module according to claim 3, wherein the aperture of the porosity is 0.001 to 50µm.

5. The heat dissipation module according to claim 4, further comprising another thermal conductive device between the heating electrical component and the cooling body.

6. The heat dissipation module according to claim 5, further comprising a plurality of fillisters on the surface of the cooling body.

7. The heat dissipation module according to claim 6, wherein the heating electrical component is one of an electrical conductive circuit, a lighting device, a CPU, a conductor and a semi-conductor.
